(19)

**Europäisches Patentamt**

**European Patent Office**

**Office européen des brevets**

(11)　**EP 4 749 926 A1**

(12)　　# EUROPEAN PATENT APPLICATION

(43) Date of publication:
　　**27.05.2026　Bulletin 2026/22**

(21) Application number: **24215053.0**

(22) Date of filing: **25.11.2024**

(51) International Patent Classification (IPC):
　　**H03L 7/08** *(2006.01)*　　　　**H03L 7/085** *(2006.01)*
　　**H03L 7/197** *(2006.01)*

(52) Cooperative Patent Classification (CPC):
　　**H03L 7/0807; G01S 13/343; G01S 13/878;**
　　**H03L 7/0805; H03L 7/085; H03L 7/1974;**
　　H03L 2207/50

(84) Designated Contracting States:
　　**AL AT BE BG CH CY CZ DE DK EE ES FI FR GB**
　　**GR HR HU IE IS IT LI LT LU LV MC ME MK MT NL**
　　**NO PL PT RO RS SE SI SK SM TR**
　　Designated Extension States:
　　**BA**
　　Designated Validation States:
　　**GE KH MA MD TN**

(71) Applicant: **NXP USA, Inc.**
　　**Austin, TX 78735 (US)**

(72) Inventors:
　　• **Vaucher, Cicero Silveira**
　　　**5656AG Eindhoven (NL)**

　　• **Jansen, Feike Guus**
　　　**5656AG Eindhoven (NL)**
　　• **Klaassen, Marc**
　　　**5656AG Eindhoven (NL)**

(74) Representative: **Hardingham, Christopher Mark**
　　**NXP Semiconductors**
　　**Intellectual Property Group**
　　**The Cattle Barn**
　　**Upper Ashfield Farm, Hoe Lane**
　　**Romsey, Hampshire SO51 9NJ (GB)**

Remarks:
　　Amended claims in accordance with Rule 137(2)
　　EPC.

(54)　**REMOTE FREQUENCY REFERENCE SYNCHRONIZATION**

(57)　　An apparatus and method for synchronizing a reference oscillator. A frequency of an adjustable frequency reference oscillator is adjusted based on an indication that radio signal processing is inactive and based on a phase error between a synchronized frequency reference signal and a frequency based on a synchronization reference signal. The adjustable frequency reference oscillator provides the synchronized frequency reference signal for a radio frequency circuit and a timing signal indicates whether radio signal processing by a radio frequency circuit is active or inactive. Adjustment of the frequency of the adjustable frequency reference oscillator is inhibited based on the timing signal indicating that radio signal processing is active.

FIG. 2

**EP 4 749 926 A1**

**Description**

BACKGROUND

Field

Embodiments of the present invention generally relate to adjusting frequencies of electrical frequency reference signal generators, and more particularly, relate to synchronization of separated electrical frequency reference signal generators.

Related Art

A Distributed Coherent Radar (DCR) system includes multiple radar transmitters and receivers that are physically separated from one another but that operate together by coherently combining received reflected radar signals that originate from other transmitters in the system. Such multiple radar transmitters and receivers are sometimes installed at separate physical locations that are near each other, and may be installed on a single structure such as an automobile. The separation of these physical installation locations can add difficulty in distributing a common radio frequency reference signal suitable to synchronize the coherent radio frequency processing of these different transmitters and receivers.

BRIEF DESCRIPTION OF THE DRAWINGS

Embodiments of the present invention is illustrated by way of example and is not limited by the accompanying figures, in which like references indicate similar elements. Elements in the figures are illustrated for simplicity and clarity and have not necessarily been drawn to scale.

FIG. 1 illustrates a bistatic radar system, according to an example.
FIG. 2 illustrates a generalized radar head block diagram for the first radar head of the above described bistatic radar system of FIG. 1, according to an example.
FIG. 3 illustrates a DCXO based radar head block diagram for the first radar head of the above described bistatic radar system of FIG. 1, according to an example.
FIG. 4 illustrates a phase locked loop (PLL) controlled radar head block diagram for the first radar head of the above described bistatic radar system of FIG. 1, according to an example.
FIG. 5 illustrates an adjustable frequency reference oscillator block diagram, according to an example
FIG. 6 illustrates a frequency command generator block diagram, according to an example.
FIG. 7 illustrates a chirp ramp and reference oscillator synchronization waveforms, according to a first example.
FIG. 8 illustrates a chirp sequence and reference oscillator synchronization waveforms, according to a second example.
FIG. 9 illustrates a frequency reference oscillator synchronization processing flow, according to an example.
FIG. 10 illustrates a frequency synchronization processing flow, according to an example.
FIG. 11 illustrates a PLL operation flow, according to an example.
FIG. 12 is a diagram illustrating one example of an information processing system according to one or more embodiments of the present invention.

DETAILED DESCRIPTION

The below described systems and methods operate to synchronize different receivers and transmitters that are part of a distributed coherent radar system. The below described systems and methods in an example adjust the frequency and phase of frequency references used by each receiver and transmitter so as to be synchronized to a recovered data symbol clock. The recovered data symbol clock supports clock synchronization between a central controller and the receivers and transmitters used in the distributed radar system. By synchronizing all receivers and transmitters to the data symbol clock originating from a common central controller, synchronization of all receivers and transmitters is achieved. In an example, the phase of the signal generated by a frequency reference generator feeding each receiver and transmitter is only adjusted when no radio frequency reception or transmission is occurring. Limiting frequency reference phase adjustments to times when no radio frequency reception or transmission occurs reduces perturbations to the frequency stability of the transmitted signals and the frequency stability of signals used to recover received radio signals.

Distributed coherent radar systems in some examples that include the below described systems and methods include two or more components, each of which is referred to herein as a "radar head" (or radar circuitry), that each includes one or more receiver circuits, transmitter circuits, receiver transmitter circuit pairs, or any combinations of these. In an example, these radar heads are part of a multi-static Frequency Modulated Continuous Wave (FMCW) radar system where each transmitter generates and transmits a frequency modulated (FM) radio frequency (RF) signal and further operates to receive RF signals that are transmitted by one or more of that radar head, other radar heads that are part of the distributed coherent radar system, or combinations of those. In an example, each radar head generates and transmits a chirped RF waveform that consists of a sequence of a number of "chirps" where each chirp waveform has an RF frequency ramp for a defined time interval. In further examples, continuous wave radars, other distributed coherent radars, or combinations of these, are able to modulate the transmitted continuous wave RF waveform signal by using suitable techniques. The RF transmission, and thus reception, by each radar head in some distributed coherent systems are synchronized so that all transmitted waveforms all occur at the same time.

Each radar head in such distributed coherent radar systems has a reference oscillator that controls, for example, radio frequency signal local oscillators (LOs), chirp ramp timing clocks, sampling by analog to digital converters, operational aspects of other components, or combinations of these. In an example, the reference oscillator in each radar head is an adjustable frequency reference oscillator that allows adjustment of the frequency of its synchronized frequency reference signal to synchronize the frequency and phase of that adjustable frequency reference oscillator to an external frequency source and thus generate a synchronized frequency reference signal that is synchronized to the external frequency source. The below systems and methods operate to synchronize the frequency of the synchronized frequency reference signal of each of the adjustable frequency reference oscillators in each radar head so that all receivers and transmitters synchronously start their RF signal transmission and reception, and maintain coherency in their frequency ramps during each chirp ramp, to within a tolerance limit. Such synchronization limits time offsets between different transmitters and receivers of a multistatic radar system throughout radar measurements. The below described systems and methods are generally applicable to bistatic or multistatic radar installations.

The below described systems and methods provide techniques that operate to synchronize one or more reference oscillators that provide synchronized frequency reference signals for each radar head based on a recovered data clock as is determined by an Ethernet receiver in the respective radar head. In an example, the Ethernet receiver operates to exchange data with a central control element that communicates with all radar heads in the distributed coherent radar system. The recovered data clock is used by the Ethernet receiver to support reception of data conveyed over the Ethernet link. This recovered data clock that is determined by the Ethernet receiver in each radar head is also used in some examples as an external frequency reference signal to synchronize the adjustable frequency reference oscillator in that radar head. In some of the below described examples, less expensive crystals and crystal oscillator architectures are able to advantageously be used to generate synchronized frequency reference signals at each radar head that operates as part of a distributed coherent radar system. Because each radar head receives data from a single central control element, that central control element is able to send data with the same data clock to all of the radar heads in the multistatic radar system and thus all radar heads are synchronized to each other and are able to support coherent operations. In some examples, a Digitally Controlled Crystal Oscillator (DCXO) is able to be used to control the output frequency of an adjustable frequency reference oscillator. In some examples, a simpler adjustable oscillator configuration is able to be used to obviate the use of more expensive frequency reference oscillators such as DCXOs.

In some examples, a recovered Ethernet data clock may exhibit timing jitter over short periods. In order to improve the characteristics of the generated frequency reference signal in light of this jitter, an example of the below described systems and methods limit performing frequency corrections of the reference oscillator of each radar head to time intervals where the radar head is not performing radio signal processing. As used herein, the term "radio signal processing" refers to generation and processing of signals during radio frequency signal transmission, reception, or both transmission and reception. In general, radio signal processing may or may not include processing of data recovered from received radio signals. Some examples of the below described processing operate to address timing jitter that may occur during data clock recovery by the Ethernet receiver.

In some examples, the below described systems and methods include radar heads that each has a timing controller that produces a timing signal that controls timing of processing associated with the transmission and reception of the frequency modulated continuous wave (FMCW) waveforms used by the multistatic radar system. The timing signal, which controls the transmission and reception of the FMCW waveforms in the radar heads of some examples of the below described systems and methods, is further used to control the time interval during which synchronization of the frequency and phase of the adjustable frequency reference oscillators of each radar head occurs. In an example, these adjustable frequency reference oscillators are synchronized at times when there is no radio signal processing, e.g., when the transmitters are not transmitting the FMCW signal, and the receivers are also not performing reception processing. Such operations result in adjusting the adjustable frequency reference oscillator during times when radio signal processing by the transmitter and receiver are not being performed. In such examples, when radio signal processing is performed, adjustment of the adjustable frequency reference oscillators is suspended thus allowing radio signal processing to proceed with a synchronized frequency reference signal having the stability of its local frequency reference oscillator, such as a crystal oscillator, unperturbed by synchronization of the adjustable frequency reference oscillator to the recovered data clock.

The below described systems and methods provide several advantages relative to conventional approaches. For example, some multi-static radar systems have a separate local frequency reference oscillator with a fixed crystal based frequency for each radar head. Due to tolerances, typically expressed in part per million (ppm), the crystals in each subsystem operate at slightly different clock frequencies. Therefore, the desired frequency and time offsets between radars cannot be maintained for a radar measurement of reasonable duration. The radar measurements of each radar may have slightly different durations from each other and the RF carrier frequencies may be slightly off from the nominal target values for which the frequency reference oscillators are configured. These circumstances cause a blurring of the point target radar response, leading to lower distance and relative velocity separability as well as decreased received Signal to Noise Ratio (SNR). Limiting adjustments to times when no radio signal processing occurs improves the performance of synchronizing the adjustable frequency reference oscillator so as not to induce recovered data clock frequency jitter into the frequency reference during times of radio signal processing.

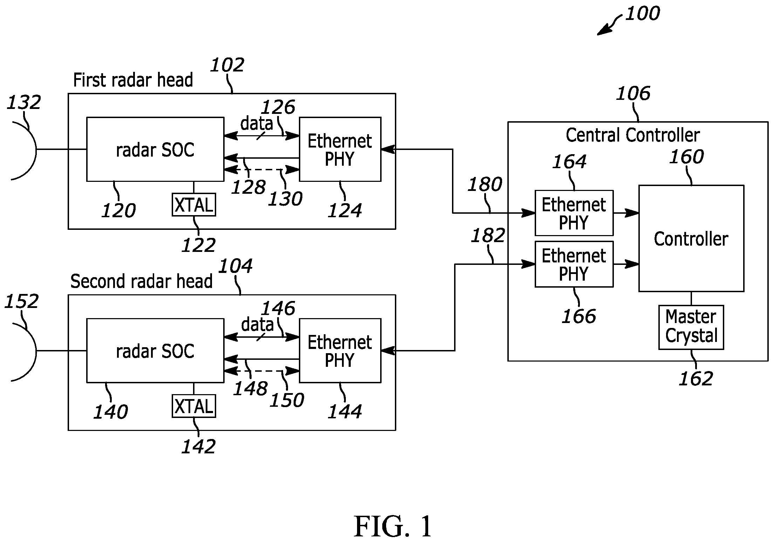

FIG. 1 illustrates a bistatic radar system 100, according to an example. The illustrated bistatic radar system depicts two radar heads (also referred to as radar head circuits), including a first radar head 102 and a second radar head 104. In order to more concisely describe the relevant aspects of the present examples, a bistatic radar system 100 is depicted as an example and it is to be understood that the concepts described for this example are readily applied to a multi-static radar system with any number of radar heads. In an example, the multiple radar heads are mounted in different positions on a structure, such as a vehicle.

The illustrated bistatic radar system 100 further includes a central controller 106. The central controller 106 includes controller circuitry 160 that is a processor that receives data from all of the multiple radar heads and processes that data to produce information derived from the combination of signals received by and sent to the controller circuitry 160 by the individual radar heads, such as information characterizing received RF signals.

The illustrated central controller 106 communicates with each radar head via an ethernet link that is depicted as a different link for each radar head. In further examples, a single Ethernet link is able to communicate with multiple radar heads. In the illustrated example, the central controller 106 communicates with the first radar head 102 via a first ethernet link 180 and the second radar head via a second ethernet link 182. Each of these ethernet links has an ethernet physical layer (PHY) controller, e.g., a first central controller PHY controller 164 and a second central controller PHY controller 166, respectively. The components of the central controller 106 in an example receive a local frequency reference signal from a master crystal 162. This local frequency reference signal in an example controls the data clocks of all of the ethernet PHY controllers within the central controller 106. This causes the data clocks of all of the ethernet PHY controllers to be synchronized to each other.

The illustrated first radar head 102 includes a first radar System On Chip (SOC) circuit 120 that includes one or more various distributed coherent radar components that support radar operations such as, for example, a radio frequency circuit and other components that include one or more distributed coherent radar components that perform radio signal generation, radio signal reception, received signal processing, other processing, or combinations of these. In further examples, such radar processing is able to be implemented by any suitable architecture including discrete components, partially integrated components, other architectures, or combinations of these.

The first radar SOC circuit 120 further exchanges radio frequency (RF) signals with a first antenna system 132 to transmit and receive RF signals. In various examples, the first antenna system 132 is able to include one or more antennas that each operates to efficiently transit, receive, transmit and receive, or combinations of these, the RF signals that are generated or received by the first radar SOC circuit 120.

The first radar head 102 includes a first ethernet physical layer (PHY) interface 124. The first ethernet PHY interface 124 in an example operates to exchange data between the first radar SOC 120 and the controller circuitry 160 via the first ethernet link 180. In the course of receiving data via the first ethernet link 180, the first ethernet PHY interface 124 operates to recover a data clock for the first ethernet link 180. The first ethernet PHY interface 124 in an example communicates over a wired ethernet link and includes a wired communications data clock recovery circuit that produces a first recovered data clock 128 that is an example of a synchronization reference signal. In the following discussion, the synchronization reference signal is referred to as the first recovered data clock 128 but it is to be understood that the signal carried by the synchronization reference signal is able to be based on the recovered data clock and not a direct version of the actual recovered data clock but may, for example, be transformed so as to have a different frequency or other characteristics. The first recovered data clock 128 is provided to the first radar SOC circuit 120 to support processing to synchronize a reference oscillator in the first radar SOC circuit 120 to the frequency and phase of the recovered data clock. As described in further detail below, each radar head, including the first radar head 102, synchronizes an adjustable frequency reference oscillator used by the radar SOC circuit in that radar head with the recovered data clock that is determined the ethernet PHY controller in that radar head.

The first radar SOC circuit 120 receives a local frequency reference signal from a local oscillator, such as the illustrated first local crystal (XTAL) 122. The first local crystal 122 in an example generates a local frequency reference signal that is used as a timing basis for an adjustable frequency reference oscillator within the first radar SOC circuit 120. As is described in further detail below, an output frequency of an adjustable frequency reference oscillator is adjusted based on the frequency of a recovered data clock as determined by the first ethernet PHY interface 124.

The first radar SOC circuit 120, in an example, processes RF signals during particular time intervals. The processing of these RF signals is referred to herein as radio signal processing. During radio signal processing, the first radar SOC circuit 120 generates RF signals for transmission and conversely receives RF signals. These time intervals of radio signal processing are separated by time intervals that are referred to as reset periods. The first radar SOC circuit 120 in an example limits reception of RF signals to the time interval of radio signal processing. In some examples, an RF receiver in the first radar SOC circuit 120 collects data or other information based on or characterizing the RF signals received during the intervals of radio signal processing and continues to process that data or other information after the interval of radio signal processing.

In an example, processing in the first radar SOC circuit 120 activates or deactivates radio signal processing based on timing signals generated within the first radar SOC circuit 120. These timing signals are based on the synchronized frequency reference signal produced by the adjustable frequency reference oscillator within the first radar SOC circuit 120 where that adjustable frequency oscillator is synchronized to the received data clock as discussed above and described in further detail below. In the illustrated example, the timing signal that operates to activate or deactivate radio signal processing in the first radar SOC circuit 120 is provided to other processing components to indicate whether radio signal processing by the radio frequency circuit is active or inactive as a basis to inhibit or perform processing to synchronize an adjustable frequency reference oscillator in that first radar SOC circuit 120.

In examples where the processing to synchronize the adjustable frequency reference oscillator in the first radar SOC circuit 120 is activated or deactivated by a timing signal, the first ethernet PHY interface 124 receives that timing signal as a first enable reference signal 130. In the illustrated example, the first enable reference signal 130 is an example of a timing signal. The first enable reference signal 130 in an example controls the processing by the first ethernet PHY interface 124 to produce a first recovered data clock 128 to be provided to the first radar SOC circuit 120. In the illustrated example, the first enable reference signal 130 is asserted when a timing signal indicates that radio signal processing is inactive and is not asserted when the timing signal indicates that radio signal processing is active. In the illustrated example, when the first enable reference signal 130 indicates that radio signal processing is active, operations of the wired communications data clock recovery circuit in the first ethernet PHY interface 124 is inhibited.

In an example, when the first enable reference signal 130 is asserted, indicating that radio signal processing is inactive, the first ethernet PHY interface 124 performs processing to recover the ethernet data clock and provide a recovered data clock frequency signal to the first radar SOC circuit 120. When the first enable reference signal 130 is not asserted, indicating that radio signal processing is active, the first ethernet PHY interface 124 disables recovery of the data clock reference signal. In some examples, recovering the data clock reference signal is not enabled during radio frequency processing activity to avoid a possibility of interference on radar transmission or reception operations. In some examples, the frequencies present at the first ethernet PHY interface 124 may not be compatible with the radio frequency plan of the first radar SOC circuit 120 so a possibility of interference to the RF processing of the first radar SOC circuit is obviated in these examples by disabling data clock recovery during RF processing activity.

The second radar head 104 includes components that correspond to the above described components of the first radar head 102. The second radar head 104 includes a second radar SOC circuit 140, a second antenna system 152, a second local crystal 142, and a second ethernet PHY controller 144, that operate in a manner similar to the above described first radar SOC circuit 120, first antenna system 132, first local crystal 122, and the first ethernet PHY interface 124. The second ethernet PHY controller 144 further has a second data interface 146, a second recovered data clock signal 148, and a second enable reference signal 150 that operates in a manner similar to the above described first data interface 126, first recovered data clock 128, and the first enable reference signal 130.

The above described processing is also performed to synchronize the adjustable frequency reference oscillator of the second radar SOC circuit 140 to the recovered data clock produced by the second ethernet PHY controller 144. In the illustrated example, because the adjustable frequency reference oscillator of the second radar SOC circuit 140 and the adjustable frequency reference oscillator of the first radar SOC circuit 120 are both synchronized to recovered data clocks that originate from the same central controller 106, the first radar SOC circuit 120 and the second radar SOC circuit 140 are time and frequency synchronized to each other to within a tolerance.

In various examples, the first radar head 102 and the second radar head 104, along with their corresponding antenna systems, are mounted on a structure, such as a vehicle, such that the antenna systems share a partially overlapping Field of View (FoV). The central controller 106 sends ethernet data whose recovered data clock is used to synchronize the adjustable frequency reference oscillators of each radar head to a common frequency reference, where synchronization to that common frequency reference is accomplished by synchronization to the common data communications symbol clock of data communicated between the central controller 106 and each radar head. This operation causes all radar heads to have synchronized frequency reference signals and thus the combination of the multiple radar heads and central controller are able to operate as a Distributed Coherent Radar (DCR) system.

In an example, each radar head sends raw data, e.g., time domain analog to digital converter (ADC) samples or transformed values of those samples, such as transformation of the time domain ADC samples into the frequency domain, to the central controller 106. In some examples, the data sent by each radar head are able to be compressed. In some examples, the central controller 106 performs various forms of signal processing on the received data to produce one or more outputs that represents the DCR radar system perception of the environment. In an example, such perceptions of the environment include the position and velocity of objects in the vicinity of the installed radar heads.

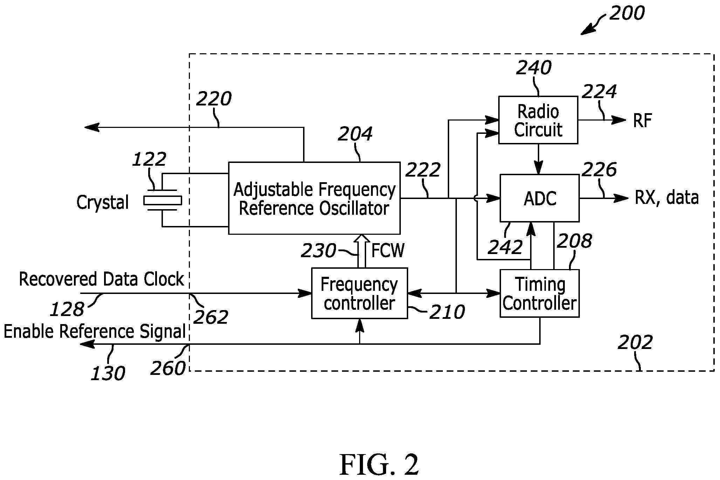

FIG. 2 illustrates a generalized radar head block diagram 200 for the first radar head 102 of the above described bistatic radar system 100 of FIG. 1, according to an example. The generalized radar head block diagram 200 includes components relevant to the description of the below described systems and methods. The generalized radar head block diagram 200 includes the above described first local crystal 122, the first recovered data clock 128 and the first enable reference signal 130. A generalized radar SOC partial block diagram 202 depicts portions of the above described first radar SOC circuit 120 that are relevant to the concepts of the system and methods being described.

The generalized radar SOC partial block diagram 202 includes an adjustable frequency reference oscillator 204 in an example that produces a local frequency reference signal 220 based on the first local crystal 122. The adjustable frequency reference oscillator 204 further generates a synchronized frequency reference signal 222 that in an example is synchronized to the recovered data clock frequency as is described above. The adjustable frequency reference oscillator 204 has a frequency command input 230 that operates to receive Frequency Control Words (FCW). The adjustable frequency reference oscillator 204 includes circuitry that operates to generate and provide a synchronized frequency reference signal 222 that has a frequency that corresponds to values of frequency control words (FCWs) received via the frequency command input 230. As described below, components of each radar head operate to generate frequency control words (FCWs) to adjust the frequency of the synchronized frequency reference signal 222 so as to maintain synchronization with the frequency of the recovered data clock. In some examples, the frequency of the synchronized frequency reference signal 222 is able to be the frequency of the recovered data clock multiplied by an integer or fractional scaling factor.

The synchronized frequency reference signal 222 is provided to various components including a radio frequency circuit 240, which includes a chirp generator circuit that performs radio signal processing including producing a local oscillator output that is upconverted to an RF output 224 to drive radio frequency transmit and receive operations. The synchronized frequency reference signal 222 is also provided to an Analog-to-Digital Converter (ADC) 242 that operates to digitize received radio frequency waveforms. The synchronized frequency reference signal 222 is further provided to a timing controller circuit 208 and a frequency controller circuit 210.

The frequency controller circuit 210 in an example operates to compare deviations from a desired relationship between the synchronized frequency reference signal 222 and the first recovered data clock 128 in order to determine and produce a Frequency Control Word (FCW) that is provided to the adjustable frequency reference oscillator 204 via the frequency command input 230. The FCW specifies a value indicating a frequency of the synchronized frequency reference signal 222 to be produced by the adjustable frequency reference oscillator 204. In an example, the frequency controller circuit 210 operates to adjust a frequency of the adjustable frequency reference oscillator 204 based on a phase error between the synchronized frequency reference signal 222 and a frequency based on a synchronization reference signals, which is the first recovered data clock 128 in the illustrated example. Examples of a frequency controller circuit 210 are described in further detail below. Such processing in an example operates to minimize the value of such a phase error between those two signals. It is to be understood that minimizing a phase error between the synchronized frequency reference signal 222 and a frequency based on a synchronization reference signals also minimizes any frequency errors between those signals because of the close relationship between the frequencies of two signal with minimum, or constant, phase error. In an example, the generalized radar SOC partial block diagram 202 includes a recovered data clock input 262 that in the illustrated example receives the first recovered data clock 128 from the first ethernet PHY interface 124.

The timing controller circuit 208 in an example generates and provides timing signals that operate to activate or deactivate radio signal processing in the first radar SOC circuit 120 including, but not limited to, the Analog-to-Digital Converter (ADC) 242 and the radio frequency circuit 240. As is described in further detail below, timing signals generated by the timing controller circuit 208 control the operation of the frequency controller circuit 210 so that frequency control words provided to the frequency command input 230 are only updated during periods when radio signal processing by the radio frequency circuit is inactive. An example of timing signals generated by the timing controller circuit 208 are described above as the enable reference signal 130. The timing controller circuit 208 further generates a first enable reference signal 130 that indicates whether radio signal processing by the radio frequency circuit is active or inactive. The use of the first enable reference signal 130 is described in further detail below. In an example, the radar SOC partial block diagram 202 includes an enable reference signal interface 260 that in the illustrated example provides the first enable reference signal 130 to the first ethernet PHY interface 124.

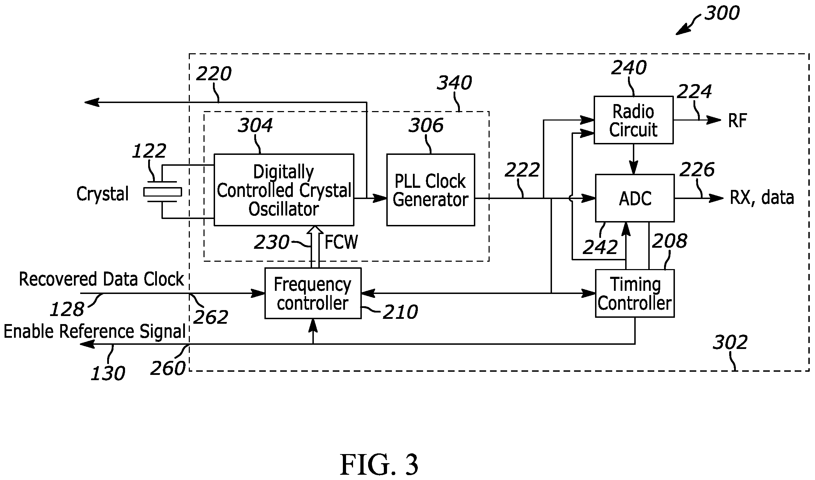

FIG. 3 illustrates a Digitally Controlled Crystal Oscillator (DCXO) radar head block diagram 300 for the first radar head 102 of the above described bistatic radar system 100 of FIG. 1, according to an example. The DCXO radar head block diagram 300 includes the components described above with regards to the generalized radar head block diagram 200 and depicts details of a first alternative adjustable frequency reference oscillator 340, which is an example of the above described adjustable frequency reference oscillator 204.

The DCXO radar head block diagram 300 depicts a first alternative radar SOC partial block diagram 302 with a first alternative adjustable frequency reference oscillator 340. The first alternative adjustable frequency reference oscillator 340 includes a digitally controlled crystal oscillator (DCXO) 304 that produces the local frequency reference signal 220 based on the first local crystal 122. This local frequency reference signal 220 in the first alternative adjustable frequency reference oscillator 340 is provided to a first alternative Phase Locked Loop (PLL) clock generator circuit 306. The first alternative PLL clock generator circuit 306 generates a synchronized frequency reference signal 222 that is locked to a frequency based on the frequency of the local frequency reference signal 220. As described in further detail below, the frequency of the synchronized frequency reference signal 222 in an example is synchronized to the first recovered data clock 128 by commanding adjustments to the DCXO 304 and thus the frequency of the synchronized frequency reference signal 222 produced by the first alternative PLL clock generator circuit 306.

In an example, the DCXO 304 has the frequency command input 230 that operates to receive frequency control words. The frequency control words produced by the frequency controller circuit 210 are provided to the frequency command input 230 of the digitally controlled crystal oscillator 308, which then causes the DCXO 304 to adjust the frequency of the local frequency reference signal 220 according to the received frequency control word. The adjusted frequency of the local frequency reference signal 220 controls the output frequency of the synchronized frequency reference signal 222 generated by the first alternative PLL clock generator circuit 306. In an example, the first alternative PLL clock generator circuit 306 does not have an interface to receive a frequency control word. The synchronized frequency reference signal 222 is provided to the frequency controller circuit 210 and compared to the first recovered data clock 128 to provide closed loop frequency tracking by controlling the frequency of the DCXO 304 output that controls the frequency produced by the first alternative PLL clock generator circuit 306.

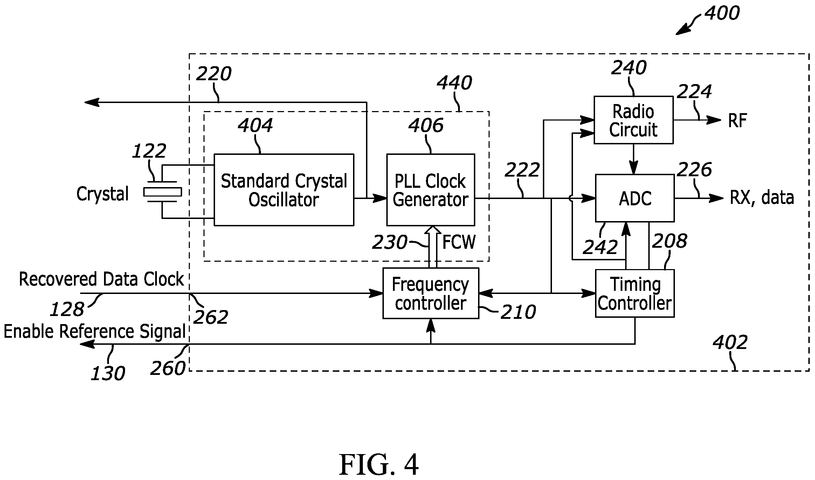

FIG. 4 illustrates a PLL controlled radar head block diagram 400 for the first radar head 102 of the above described bistatic radar system 100, according to an example. The PLL controlled radar head block diagram 400 includes the components described above with regards to the generalized radar head block diagram 200 and depicts details of a second alternative adjustable frequency reference oscillator 440, which is an example of the above described adjustable frequency reference oscillator 204.

The PLL controlled radar head block diagram 400 depicts a second alternative radar SOC partial block diagram 402 where the second alternative adjustable frequency reference oscillator 440 includes a standard crystal oscillator 404 to produce the local frequency reference signal 220 based on the first local crystal 122. In contrast to the above described Digitally Controlled Crystal Oscillator (DCXO) radar head block diagram 300, which has its output frequency controlled by a variable frequency digitally controlled crystal oscillator (DCXO) 304, the standard crystal oscillator 404 incorporates a conventional fixed frequency oscillator with an output frequency controlled by the first local crystal 122. This local frequency reference signal 220 is provided to a second alternative Phase Locked Loop (PLL) clock generator circuit 406. The second alternative PLL clock generator circuit 406 generates a synchronized frequency reference signal 222 that in an example is synchronized to the recovered data clock frequency based on the received frequency control words (FCWs) as is described above.

The second alternative PLL clock generator circuit 406 has the frequency command input 230 that operates to receive Frequency Control Words (FCW). The second alternative PLL clock generator circuit 406 operates to generate a synchronized frequency reference signal 222 that has a frequency that corresponds to values of frequency control words (FCWs) received via the frequency command input 230. As described below, components of each radar head operate to generate frequency control words to adjust the frequency of the synchronized frequency reference signal 222 so as to maintain synchronization with the recovered data clock.

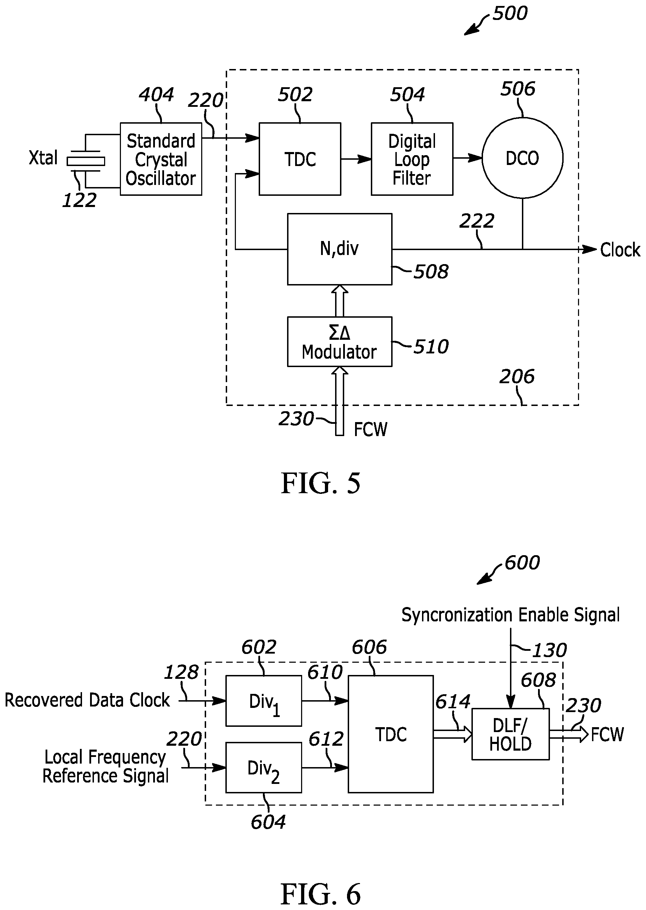

FIG. 5 illustrates an adjustable frequency reference oscillator block diagram 500, according to an example. The adjustable frequency reference oscillator block diagram 500 depicts components that are part of the above described second alternative PLL clock generator circuit 406 and standard crystal oscillator 404 along with other components of an example radar head.

The components of the illustrated example second alternative PLL clock generator circuit 406 form an All Digital Phase Locked Loop (ADPLL) that outputs a synchronized frequency reference signal 222 based on a local frequency reference in the form of the standard crystal oscillator 404 and controlled by a frequency control word (FCW) that is received from the frequency controller circuit 210 via a frequency command input 230.

The second alternative PLL clock generator circuit 406 includes a Digitally Controlled Oscillator (DCO) 506 that produces the synchronized frequency reference signal 222. The synchronized frequency reference signal 222 is provided to a divide-by-N processor circuit 508 that is an example of a programmable frequency divider that divides the frequency of the pulse train of the synchronized frequency reference signal 222 by a divisor command. In the illustrated example, the divisor command is an integer N value that is received by the divide-by-N processor circuit 508 from a Sigma-Delta ($\Sigma\Delta$) modulator circuit 510. The Sigma-Delta ($\Sigma\Delta$) modulator circuit 510 in an example receives a time sequence of frequency control words (FCW) via the frequency command input 230 as an input to the second alternative PLL clock generator circuit 406 and processes the time sequence of those frequency control words to generate a divisor command to support fractional-N programming of the synchronized frequency reference signal 222.

The output of the divide-by-N processor circuit 508 is provided as an input to a Time-to-Digital Converter (TDC) circuit 502 that also receives an input from the standard crystal oscillator 404. The time-to-digital converter (TDC) circuit 502 compares the time difference of the two active edges at its input, i.e., the output of the standard crystal oscillator 404 and the output of the divide-by-N processor circuit 508 in this example, and provides a digital value that is proportional to the phase difference between those two signals. This digital value is provided to a digital loop filter circuit 504 that indicates the time separation between those active edges. The time separation between these two signals corresponds to the phase difference between those two signals. The output of the digital loop filter circuit 504 is provided as a control input to the digitally controlled oscillator (DCO) 506 to complete the Phase Locked Loop (PLL). The operation of the above described components adjusts the frequency of the synchronized frequency reference signal produced by the digitally controlled oscillator (DCO) 506 based on the phase error between the synchronized frequency reference signal 222 and a frequency based on a synchronization reference signal such as the first recovered data clock 128.

The presently described example uses an all-digital phased locked loop design to generate the synchronized frequency reference signal 222 and employs digital circuits to support other operations to synchronize the synchronized frequency reference signal 222 to the first recovered data clock 128. Further examples are able to include analog circuits to perform part or all of these functions, such as but not limited to, phase locked loop processing, phase difference processing, other processing, or combinations of these.

FIG. 6 illustrates a frequency command generator block diagram 600, according to an example. The frequency command generator block diagram 600 is an example of components within the above described frequency controller circuit 210. The components within the frequency command generator block diagram operate to determine values by which to adjust the frequency of the synchronized frequency reference signal 222 that is the output of the adjustable frequency reference oscillator 204. In some examples, a frequency controller circuit 210 containing components illustrated by the frequency command generator block diagram 600 are able to provide frequency commands in the form of frequency control words to either the first alternative adjustable frequency reference oscillator 340 or the second alternative adjustable frequency reference oscillator 440. The frequency controller circuit 210 in this example compares the frequency of the synchronized frequency reference signal 222 and the frequency of the first recovered data clock 128 to determine frequency commands to provide to the adjustable frequency reference oscillator 204 to maintain frequency synchronization of the synchronized frequency reference signal 222 with the frequency standard provided by the first recovered data clock 128.

The frequency command generator block diagram 600 contains a first frequency divider circuit 602 that divides the frequency of the first recovered data clock 128 by a first divisor, or constant Divi to produce a frequency divided recovered data clock signal 610 as an output. The frequency command generator block diagram 600 also contains a second frequency divider circuit 604 that divides the frequency of the synchronized frequency reference signal 222 by a second divisor or constant $Div_2$ to produce a frequency divided frequency reference signal 612 as an output.

The first frequency divider circuit 602 and the second frequency divider circuit 604 operate to scale and equalize the nominal frequency of the signals at the input of a Time-to-Digital Converter (TDC) circuit 606 such that:

$$\text{Recovered clock frequency} / \text{Div}_1 \sim \text{synchronized frequency reference output} / \text{Div}_2$$

Rearranging these terms and substituting the approximation with an equality yields:

$$\text{Synchronized frequency reference output} = \text{Div}_2 * \text{Recovered clock Frequency} / \text{Div}_1 \ [1]$$

In examples where a rational relationship exists, i.e. where equation [1] can be realized with integer values for Divi and $Div_2$ for the frequency of the synchronized frequency reference signal 222 and the first recovered data clock 128, those integer values can be directly used for Divi and $Div_2$. In cases where there is not such a rational relationship, an additional sigma-delta modulator (not shown) is able to be added to, for example, the input of the second frequency divider circuit 604, effectively creating a fractional-N frequency multiplier function to drive the second frequency divider circuit 604 in order to maintain the frequency and phase-lock of the adjustable frequency reference oscillator 204 to the first recovered data clock 128

The frequency divided recovered data clock signal 610 and the frequency divided frequency reference signal 612 are provided as inputs to a Time-to-Digital Converter (TDC) circuit 606 that produces a time difference output 614 that is proportional to a time difference between the arrival of leading edges of its two inputs and thus a phase difference between those two signals. The time difference output 614 is provided to a Digital Loop Filter (DLF) circuit 608, which includes a hold circuit that is deactivated and activated by the first enable reference signal 130. The digital loop filter circuit 608 in an example is considered as part of the time-to-digital converter structure and operates to create a frequency control word (FCW) to send over a frequency command input 230 of the adjustable frequency reference oscillator 204 in a form suitable for input to the particular alternative of the adjustable frequency reference oscillator 204 receiving the FCW.

When adjustment of the second alternative PLL clock generator circuit 406 by the recovered data clock is enabled, i.e., when first enable reference signal 130 is enabled, the frequency controller circuit 210 provides updated frequency control words (FCWs) through the frequency command input 230 to the adjustable frequency reference oscillator 204. In the illustrated example, the hold circuit of the Digital Loop Filter (DLF) circuit 608 deactivates and allows updated FCWs to pass through to the frequency command input 230. The frequency controller circuit 210, in combination with the components describe above with regards to the adjustable frequency reference oscillator, operates to adjust the frequency of the synchronized frequency reference signal 222 to maintain synchronization with the recovered data clock. When the first enable reference signal 130 is not enabled, the hold circuit of the Digital Loop Filter (DLF) circuit 608 activates and in an example maintains a fixed value of its last produced FCW as an output to the frequency command input 230. The hold circuit maintaining that fixed value of the last produced FCW causes the adjustable frequency reference oscillator 204 to not adjust its output frequency based on updated FCW values and thus frequency adjustments of the adjustable frequency reference oscillator 204 is inhibited.

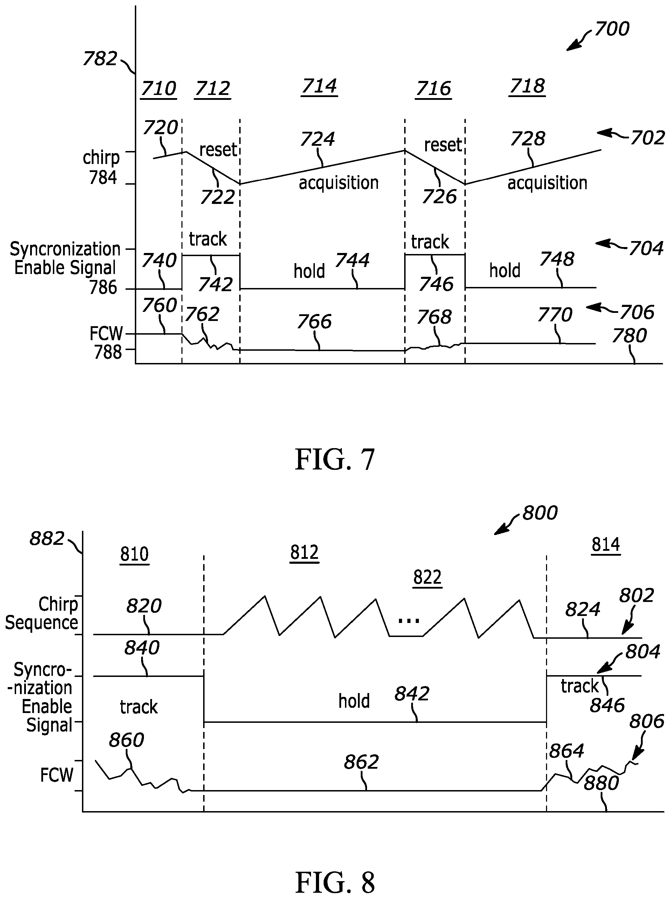

FIG. 7 illustrates a chirp ramp and reference oscillator synchronization waveforms 700, according to a first example. The chirp ramp and reference oscillator synchronization waveforms 700 illustrate an example of a Radio Frequency (RF) frequency curve 702 of a transmitted radar signal generated by a radar head, such as the first radar head 102 described above, along with a control waveform 704 and frequency control word (FCW) values 706.

In the illustrated example, the transmitted RF signal is a chirped Frequency Modulated Continuous Wave (FMCW) waveform with a linear frequency ramp that is followed by a reset period. The linear frequency ramp of the transmitted RF signal is the active period of RF radio signal processing activity during which received waveforms are processed to collect received signal characteristics data to support processing to determine, for example, locations and velocities of objects near the antenna receiving the signal. The period during the linear frequency ramp of the transmitted RF signal is referred to herein as an "acquisition" period because it is the period when radio signal processing activity acquires information indicating the characteristics of the received RF signal.

The reset period in this example is an interval of time in this example that follows a linear RF frequency ramp where the RF frequency returns to its value for the start of the next frequency ramp. The generated RF waveform in some examples is able to continue to be generated and transmitted during the reset period. In alternative examples, one or more of the generation, transmission, generation and transmission, or combinations of these is able to be inhibited during the reset period.

The chirp ramp and reference oscillator synchronization waveforms 700 illustrate waveforms generated by one example of systems and methods described herein that operate to adjust an adjustable frequency reference oscillator 204, such as the above described first alternative adjustable frequency reference oscillator 340 or the second alternative adjustable frequency reference oscillator 440, during reset periods that occur between pairs of chirp ramp intervals. The illustrated example depicts such adjustments occurring each reset period, but in further examples a subset of reset periods could be used to adjust the adjustable frequency reference oscillator. An alternative example of systems and methods that operate to adjust the synchronized frequency reference between longer sequences of chirped waveforms is described below.

The control waveform 704 is an example of the above described first enable reference signal 130. As shown, the control waveform 704 is asserted, i.e., is in a "high" state in this example, during the reset periods of the RF waveform and is unasserted during the acquisition periods. The FCW values 706 correspond to the commands produced by the frequency controller 210 and provided to the adjustable frequency reference oscillator 204 as is described above.

As is depicted for the chirp ramp and reference oscillator synchronization waveforms 700, the FCW values 706 are held at a constant value during the acquisition periods. The constant value of the FCW values 706 follows from the state of the control waveform 704 being in the unasserted state and, in an example, causing the hold circuit in the above described digital loop filter circuit 608 to be in a hold state. The resulting constant value of the FCW values 706 thus suspends adjustments of the output frequency of the adjustable frequency reference oscillator 204 based on synchronization with recovered data clock signals. As described above, the first alternative adjustable frequency reference oscillator 340 and the second alternative adjustable frequency reference oscillator 440 include phase locked loop (PLL) circuits that continue to operate to control the frequency of the synchronized frequency reference signal 222 based on the output of a crystal oscillator operating with the first local crystal 122 even though the frequency control words (FCWs) are held constant. Changes of the frequency of the synchronized frequency reference signal 222 during the acquisition period in an example are thus limited to variations due to the stability of a crystal oscillator operating with the first local crystal 122.

The chirp ramp and reference oscillator synchronization waveforms 700 depict five (5) time intervals along its horizontal time axis 780. A first time interval 710 depicts an end of a frequency ramp interval, a second time interval depicts a first reset period 712, a third time interval depicts a first ramp interval 714, a fourth time interval depicts a second reset period, and a fifth time interval depicts a second ramp interval 718.

The first ramp interval 714 depicts the RF frequency curve 702, which depicts the generated and transmitted RF frequency vs time, of the generated RF signal that is transmitted by a radar head, such as the first radar head 102. As is understood by practitioners of ordinary skill in the relevant arts, a receiver of a FMCW radar tracks the transmitted frequency in order to recover information regarding objects in the vicinity of the radar antenna(s). In the present discussion, radio signal processing activity refers to processing associated with generating and transmitting RF signals and also processing associated with receiving and processing the received RF waveforms. In some examples, radio signal processing activity is able to occur outside of the time intervals during which RF signals are generated or transmitted.

The RF frequency curve 702 has a first ramp 724 during the first ramp interval 714 in this example. The control waveform 704 is in a first unasserted state 744, or in a hold state, during the first ramp interval 714. This is an example of the control waveform 704, which is an example of the above described first enable reference signal 130, indicates that radio signal processing is active. It is further noted that the FCW values 706 have a first constant value 766 reflecting that frequency adjustments to the adjustable frequency reference oscillator 204 based on the recovered data clock are suspended as is discussed above.

The RF frequency curve 702 has a second reset slope 726 during a second reset period 716. The second reset slope 726 has a downward slope indicating that the RF frequency generator circuit is returning to generating the RF frequency at the beginning of the next ramp. During the second reset slope 726, the control waveform 704 is in a first asserted state 746, which reflects that a timing signal indicates that radio signal processing is inactive. In the illustrated example, radio signal processing is deactivated so that no processing is performed on the RF signals that are transmitted or received during the second reset period 716. The control waveform 704 being in the first asserted state 746 enables adjustment of the frequency of the adjustable frequency reference oscillator 204 based on the recovered data clock signal. In the above described example, the first enable reference signal 130 input being in an asserted state 746 releases the hold state of the hold circuit in the digital loop filter circuit 608 and allows filtered FCW values determined by the frequency controller circuit 210 to be provided to the adjustable frequency reference oscillator 204. The adjustment of the adjustable frequency reference oscillator 204 is shown by a second set of FCW changes 768 in the FCW values 706 during the second reset period 716, which depicts first FCW adjustments 708 that are commanded based on the recovered data clock as is described below.

The first time interval 710 depicts an end of a ramp interval that is similar to the first ramp interval 714. The RF frequency curve 702 depicts a partial ramp 720 while the control waveform 704 is in a second unasserted state 740 and the FCW values 706 have a second constant value 762. The fifth time interval depicts a second ramp interval 718 that includes a second ramp 728 where the control waveform 704 is in a third unasserted state 748 and the FCW values 706 have a third constant value 770.

The second time interval depicts a first reset period 712 that is similar to the second reset period 716. The RF frequency curve 702 has a first reset slope 722, the control waveform 704 is in a first asserted state 742 and the FCW values 706 have a first set of FCW changes 764.

FIG. 8 illustrates a chirp sequence and reference oscillator synchronization waveforms 800, according to a second example. The chirp sequence and reference oscillator synchronization waveforms 800 illustrate processing performed by an example of systems and methods described herein that operate to adjust the adjustable frequency reference oscillator between transmissions of sequences of chirped RF waveforms.

The chirp sequence and reference oscillator synchronization waveforms 800 depict amplitudes of various signals versus time. The chirp sequence and reference oscillator synchronization waveforms 800 depict a time axis 880 and an amplitude axis 882. The time axis 880 is linear and the amplitude axis 882 depicts relative amplitudes but is not to be considered to scale.

The chirp sequence and reference oscillator synchronization waveforms 800 depict a chirp sequence RF frequency curve that reflects a FMCW modulated chirp sequence 802 that is similar to the RF frequency curve 702 described above. In an example, the radar system transmits and receives a sequence of chirp ramp waveforms that have RF frequencies indicated by the amplitude of the chirp sequence 802 and then pauses reception of signals, and in some instances also stops transmission of signals, for a time interval before resuming to send and receive the next chirp sequence. In an example, a sequence of five hundred (500) individual chirp frequency ramps are transmitted and received prior to pausing. In further examples, any number of chirp frequency ramps are able to be transmitted prior to pausing.

The processing illustrated for the chirp sequence and reference oscillator synchronization waveforms 800 performs processing to adjust the frequency of an adjustable frequency reference oscillator 204 based on the recovered data clock signal during periods of pausing between the reception of chirp sequences. During the reception of chirp sequences, adjustment of the frequency of the adjustable frequency oscillator based on the recovered data clock signal is inhibited.

The chirp sequence and reference oscillator synchronization waveforms 800 depict three time intervals, a first transmission pause interval 810, a frequency chirp transmission interval 812, and a second transmission pause interval 814. The chirp sequence and reference oscillator synchronization waveforms 800 include a chirp sequence 802, a synchronization enable signal 804, and a frequency control word (FCW) value trace 806.

The frequency chirp transmission interval 812 depict an acquisition period 822 that includes a number of RF frequency chirp ramps. The acquisition period 822 occurs while the synchronization enable signal 804 is in a disabled, or hold, level 842. While the synchronization enable signal 804 is in the disabled level 842, the frequency control word value trace 806 is at a constant level 862 due to the inhibiting adjustment of the frequency of the adjustable frequency reference oscillator 204 while the synchronization enable signal 804 is disabled and thus indicating that radio signal processing is active. The operation of the synchronization enable signal 804 to disable updates of FCW values by asserting a hold status of the hold circuit in the digital loop filter circuit 608 is discussed above. As noted above, the adjustable frequency reference oscillator 204 in some examples continues to operate as a phase locked loop to adjust its output frequency based on its local crystal oscillator during this interval.

The first transmission pause interval 810 and the second transmission pause interval 814 each have the synchronization enable signal 804 asserted as shown by the first synchronization enable assertion 840 and the second synchronization assertion 846. While the synchronization enable signal 804 is asserted, the synchronization enable signal 804 indicates that radio signal processing is inactive and the processing allows adjustment of the frequency of the adjustable frequency reference oscillator. The illustrated chirp sequence 802 is shown to have a first reset value 820 and a second reset value 824 during the first transmission pause interval 810 and the second transmission pause interval 814, respectively. Chirp sequence generation is suspended by the radio frequency circuits during the first transmission pause interval 810 and the second transmission pause interval 814. During these pause intervals, various examples may continue to generate RF signals as is shown for the first reset value 820 and the second reset value 824. In further examples, no RF is able to be generated or any RF waveform may be generated but is generally not received by a receiver. The FCW value trace 806 vary during the first transmission pause interval 810, as shown by the first set of frequency commands 860 and during the second transmission pause interval 814 as shown by the second set of frequency commands 864.

The second transmission pause interval 814 lasts for a defined period of time before a start of an adjacent acquisition period (not shown). The end of the second transmission pause interval 814 is similar to the depicted first transmission pause interval 810 such that the second reset value 824 is followed by an adjacent acquisition period (not shown) that is similar to the acquisition period 822 that follows the first reset value 820. In this example, the acquisition period 822 is separated from the adjacent acquisition period by a respective pause interval, e.g., the second transmission pause interval 814.

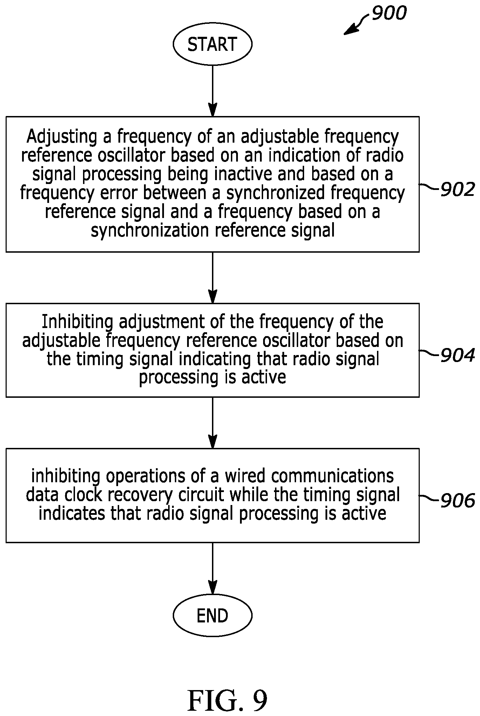

FIG. 9 illustrates a frequency reference oscillator synchronization processing flow 900, according to an example. The frequency reference oscillator synchronization processing flow 900 is an example of processing performed by a controller controlling the operations of elements a radar SOC such as the first radar SOC circuit 120.

The frequency reference oscillator synchronization processing flow 900 adjusts, at 902, a frequency of an adjustable frequency reference oscillator based on an indication of radio signal processing being inactive and based on a frequency error between a synchronized frequency reference signal and a frequency based on a synchronization reference signal. An example of such adjusting is described above with regards to the generalized radar SOC partial block diagram 202, where the frequency controller circuit 210 provides a frequency command input 230, in the form of frequency control words, to adjust the frequency of the synchronized frequency reference signal 222 produced by the adjustable frequency reference circuit 204.

The frequency reference oscillator synchronization processing flow 900 inhibits, at 904, adjustment of the frequency of the adjustable frequency reference oscillator based on the timing signal indicating that radio signal processing is active. An example of such inhibiting is described above with regards to the generalized radar SOC partial block diagram 202, where the frequency controller circuit 210 provides a frequency command input 230, in the form of frequency control words, to adjust the frequency of the synchronized frequency reference signal 222 based on the first enable reference signal 130 provided by the timing controller circuit 208 being enabled, and updates to the frequency control words are held based on the first enable reference signal 130 being disabled and indicating that radio signal processing is active.

The frequency reference oscillator synchronization processing flow 900 inhibits, at 906, operations of a wired communications data clock recovery circuit while the timing signal indicates that radio signal processing is active. An example of such inhibiting is described above with regards to the bistatic radar system 100 where the data clock recovery circuit of the first ethernet PHY interface 124 is inhibited based on the first enable reference signal 130 indicating that radio signal processing is active.

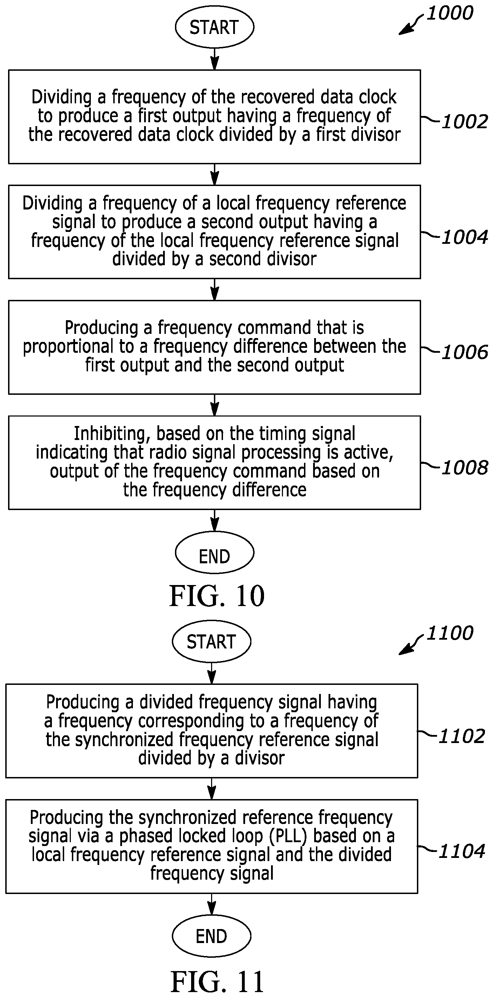

FIG. 10 illustrates a frequency synchronization processing flow 1000, according to an example. The frequency synchronization processing flow 1000 is an example of a processing flow performed by the frequency controller circuit 210 as is described above in association with the frequency command generator block diagram 600.

The frequency synchronization processing flow 1000 divides, at 1002, a frequency of the recovered data clock to produce a first output having a frequency of the recovered data clock divided by a first divisor. An example of such dividing is described in conjunction with the first frequency divider circuit 602. The frequency synchronization processing flow 1000 divides, at 1004, a frequency of a local frequency reference signal to produce a second output having a frequency of the local frequency reference signal divided by a second divisor. An example of such dividing is described in conjunction with the second frequency divider circuit 604.

The frequency synchronization processing flow 1000 produces, at 1006, a frequency command that is proportional to a frequency difference between the first output and the second output. An example of producing such a frequency command is described above with regards to the digital loop filter 608. The frequency synchronization processing flow 1000 inhibits, at 1008 based on the timing signal indicating that radio signal processing is active, output of the frequency command based on the frequency difference. An example of inhibiting such an output is described above with regards to the Digital Loop Filter circuit 608, which includes a hold circuit activated by the first enable reference signal 130.

FIG. 11 illustrates phase locked loop (PLL) operation flow 1100, according to an example. The phase locked loop operation flow 1100 is an example of an operational flow of the second alternative PLL clock generator circuit 406 as is described above with regards to the adjustable frequency reference oscillator block diagram 500.

The phase locked loop operation flow 1100 produces, at 1102, a divided frequency signal having a frequency corresponding to a frequency of the synchronized frequency reference signal divided by a divisor. The phase locked loop operation flow 1100 produces, at 1104, the synchronized frequency reference frequency signal via a phased locked loop (PLL) cirucit based on a local frequency reference signal and the divided frequency signal. Examples of such producing are described above with regards to the adjustable frequency reference oscillator block diagram 500 describing operations of an example second alternative PLL clock generator circuit 406.

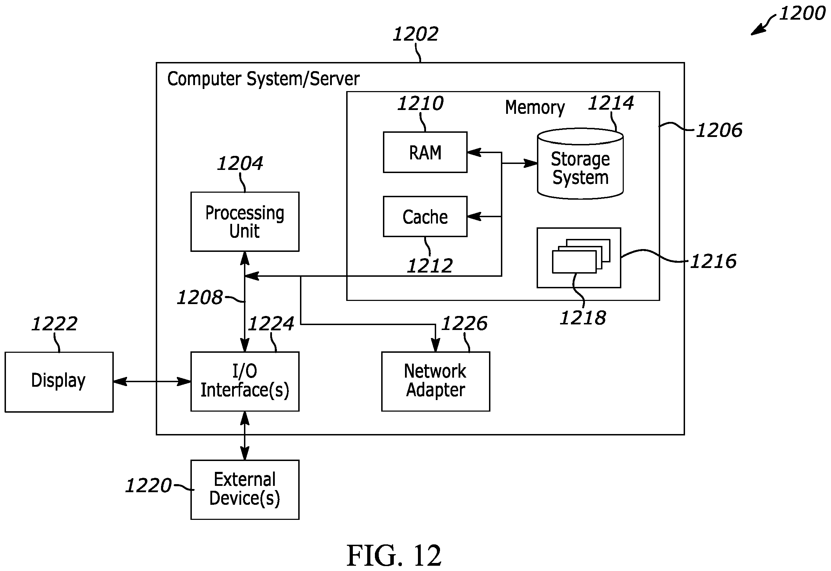

FIG. 12 is a block diagram illustrating an information processing system 1200 that can be utilized by one or more examples discussed herein. The computer system/server 1202 is based upon a suitably configured processing system configured to implement one or more embodiments of the present invention, such as elements of the above described bistatic radar system 100 or the generalized radar head block diagram 200. Any suitably configured processing system, including specialized processing systems, can be used as the computer system/server 1202. Alternatively, to the described information processing system 1200, further examples are able to be implemented in relatively small, limited purpose processors to implement the above described processing. In an example, such processors are able to be integrated with or nearby battery cell packs that are deployed in various applications. Examples of these processors are able to include any combination of general purpose processing hardware, dedicated processing hardware such as dedicated multiply and accumulate circuits, other elements, or combinations of these.

The components of the computer system/server 1202 can include but are not limited to, one or more processors, processor circuits, or processing units 1204, a system memory 1206, and a bus 1208 that couples various system components including the system memory 1206 to the processor 1204. The bus 1208 represents one or more of any of several types of bus structures, including a memory bus or memory controller, a peripheral bus, an accelerated graphics port, and a processor or local bus using any of a variety of bus architectures. By way of example, and not limitation, such architectures include Industry Standard Architecture (ISA) bus, Micro Channel Architecture (MCA) bus, Enhanced ISA (EISA) bus, Video Electronics Standards Association (VESA) local bus, and Peripheral Component Interconnects (PCI) bus.

The system memory 1206 can include computer system readable media in the form of volatile memory, such as random access memory (RAM) 1210 and/or cache memory 1212. The computer system/server 1202 can further include other removable/non-removable, volatile/non-volatile computer system storage media. By way of example only, a storage system 1214 can be provided for reading from and writing to a non-removable or removable, non-volatile media such as one or more solid-state disks and/or magnetic media (typically called a "hard drive"). A magnetic disk drive for reading from and writing to a removable, non-volatile magnetic disk (e.g., a "floppy disk"), and an optical disk drive for reading from or writing to a removable, non-volatile optical disk such as a CD-ROM, DVD-ROM or other optical media can be provided. In such instances, each can be connected to the bus 1208 by one or more data media interfaces. The memory 1206 can include at least one program product having a set of program modules that are configured to carry out the functions of an example of the present disclosure.

Program/utility 1216, having a set of program modules 1218, may be stored in memory 1206 by way of example, and not limitation, as well as an operating system, one or more application programs, other program modules, and program data. Each of the operating system, one or more application programs, other program modules, and program data or some combination thereof, may include an implementation of a networking environment. Program modules 1218 generally carry out the functions and/or methodologies of examples of the present disclosure.

The computer system/server 1202 can also communicate with one or more external devices 1220 such as a keyboard, a pointing device, a display 1222, etc.; one or more devices that enable a user to interact with the computer system/server 1202; and/or any devices, e.g., network card, modem, etc., that enable computer system/server 1202 to communicate with one or more other computing devices. Such communication can occur via I/O interfaces 1224. Still yet, the computer system/server 1202 can communicate with one or more networks such as a local area network (LAN), a general wide area network (WAN), and/or a public network, e.g., the Internet, via network adapter 1226. As depicted, the network adapter 1226 communicates with the other components of the computer system/server 1202 via the bus 1208. Other hardware and/or software components can also be used in conjunction with the information processing system 1200.

The term "coupled", as used herein, is defined as "connected" and encompasses the coupling of devices that may be physically, electrically or communicatively connected, although the coupling may not necessarily be directly and not necessarily be mechanical. The term "configured to" describes hardware, software, or a combination of hardware and software that is adapted to, set up, arranged, built, composed, constructed, designed, or that has any combination of these characteristics to carry out a given function. The term "adapted to" describes hardware, software, or a combination of hardware and software that is capable of, able to accommodate, to make, or that is suitable to carry out a given function.

The terms "a" or "an", as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to invention embodiments containing only one such element, even when the same claim includes the introductory phrases "one or more" or "at least one" and indefinite articles such as "a" or "an". The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The term "coupled", as used herein, is not intended to be limited to a direct coupling or a mechanical coupling, and that one or more additional elements may be interposed between two elements that are coupled.

As will be appreciated by one skilled in the art, aspects of the present disclosure may be embodied as a system, method, or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "circuit" or "system".

The one or more embodiments of the invention may be a system, a method, and/or a computer program product. The computer program product may include a computer-readable storage medium (or media) having computer readable program instructions thereon for causing a processor to carry out aspects of the inventive embodiments.

In one embodiment, the computer program product includes a non-transitory storage medium readable by a processing circuit and storing instructions for execution by the processing circuit for performing a method. The computer-readable storage medium can be a tangible device that can retain and store instructions for use by an instruction execution device. The computer-readable storage medium may be, for example, but is not limited to, an electronic storage device, a magnetic storage device, an optical storage device, an electromagnetic storage device, a semiconductor storage device, or any suitable combination of the foregoing. A computer-readable storage medium, as used herein, is not to be construed as being transitory signals per se, such as radio waves or other freely propagating electromagnetic waves, electromagnetic waves propagating through a waveguide or other transmission media, e.g., light pulses passing through a fiber-optic cable), or electrical signals transmitted through a wire.

Computer-readable program instructions for carrying out operations of the inventive embodiments may be assembler instructions, instruction-set-architecture (ISA) instructions, machine instructions, machine-dependent instructions, microcode, firmware instructions, state-setting data, or either source code or object code written in any combination of one or more programming languages, including an object-oriented programming language such as Smalltalk, C++, and conventional procedural programming languages, such as the "C" programming language or similar programming languages. The computer-readable program instructions may execute entirely or partly on a user's computer or entirely or partly on a remote computer or server. In the latter scenario, the remote computer may be connected to the user's computer through any type of network, including a local area network (LAN), a wide area network (WAN), an Ultra-Wide Band (UWB) network, or the connection may be made to an external computer (for example, through the Internet). In some embodiments, electronic circuitry including, for example, programmable logic circuitry, field-programmable gate arrays (FPGA), or programmable logic arrays (PLA) may execute the computer-readable program instructions by utilizing state information of the computer-readable program instructions to personalize the electronic circuitry, in order to perform aspects of the inventive embodiments.

Aspects of one or more embodiments of the invention are described herein with reference to flowchart illustrations and/or block diagrams of methods, apparatus (systems), and computer program products according to embodiments of the invention. Each block of the flowchart illustrations and/or block diagrams, and combinations of blocks in the flowchart illustrations and/or block diagrams, can be implemented by computer readable program instructions.

These computer-readable program instructions may be provided to a processor of a general-purpose computer, special purpose computer, or other programmable data processing apparatus to produce a machine, such that the instructions, which execute via the processor of the computer, create means for implementing the functions/acts specified in the flowchart and/or block diagram blocks. These computer-readable program instructions may also be stored in a computer-readable storage medium that can direct a computer to function in a particular manner, such that the computer-readable storage medium having instructions stored therein comprises an article of manufacture including instructions which implement aspects of the function/act specified in the flowchart and/or block diagram block or blocks.

In an example a reference oscillator circuit 204 includes an adjustable frequency reference oscillator circuit 204 providing a synchronized frequency reference signal 222 for a radio frequency circuit 240 where the adjustable frequency reference oscillator has a frequency command input 230. The reference oscillator further has a timing controller circuit 208 configured to, when operating, provide a timing signal 130 indicating whether radio signal processing by the radio frequency circuit is active or inactive. The reference oscillator also includes a frequency controller circuit 210 configured to, when operating and based on a synchronization reference signal 128, adjust a frequency of the adjustable frequency reference oscillator based on the timing signal indicating that radio signal processing is inactive and based on a phase error between the synchronized frequency reference signal and a frequency based on the synchronization reference signal; and inhibit adjustment of the frequency of the adjustable frequency reference oscillator based on the timing signal indicating that radio signal processing is active.

In a further example, a method of synchronizing a reference oscillator 204, the method including adjusting 902 a frequency of an adjustable frequency reference oscillator based on a timing signal 130 indicating that radio signal processing is inactive and based on a phase error between a synchronized frequency reference signal and a frequency based on a synchronization reference signal. In this example, the adjustable frequency reference oscillator 204 provides the synchronized frequency reference signal 222 for a radio frequency circuit 240; and the timing signal indicates whether radio signal processing by a radio frequency circuit is active or inactive. The method in this example also includes inhibiting 904 adjustment of the frequency of the adjustable frequency reference oscillator based on the timing signal indicating that radio signal processing is active.

In a further example, a radar system on a chip circuit 202 includes an adjustable frequency reference oscillator 202 providing a synchronized frequency reference signal 222 for a radio frequency circuit 240, the adjustable frequency reference oscillator comprising a frequency command input 230. The radar system on a chip circuit 202 also includes a timing controller circuit 208 configured to, when operating, provide a timing signal 130 indicating whether radio signal processing by the radio frequency circuit is active or inactive. The radar system on a chip circuit also has a frequency controller circuit 210 configured to, when operating and based on a synchronization reference signal: adjust 902 a frequency of the adjustable frequency reference oscillator based on the timing signal indicating that radio signal processing is inactive and based on a phase error between the synchronized frequency reference signal and a frequency based on the synchronization reference signal; and inhibit 904 adjustment of the frequency of the adjustable frequency reference oscillator based on the timing signal indicating that radio signal processing is active. The radar system on a chip circuit also includes a recovered data clock input 262, coupled to the frequency controller, configured to receive the synchronization reference signal. The radar system on a chip circuit further has an enable reference signal interface 260, coupled to the timing controller circuit, configured to output the timing signal.

The description of the present disclosure has been presented for purposes of illustration and description but is not intended to be exhaustive or limited to the inventive embodiments in the form disclosed. Many modifications and variations will be apparent to those of ordinary skill in the art without departing from the scope and spirit of the inventive embodiments. One or more embodiments were chosen and described in order to best explain the principles of the inventive subject matter and the practical application and to enable others of ordinary skill in the art to understand the inventive subject matter for various embodiments with various modifications as are suited to the particular use contemplated.

Although specific embodiments of the invention have been disclosed, those having ordinary skill in the art will understand that changes can be made to the specific embodiments without departing from the spirit and scope of the inventive embodiments. The scope of the inventive subject matter is not to be restricted, therefore, to the specific embodiments, and it is intended that the appended claims cover any and all such applications, modifications, and embodiments within the scope of the inventive subject matter.

**Claims**

1.    A reference oscillator, comprising:

an adjustable frequency reference oscillator providing a synchronized frequency reference signal for a radio frequency circuit, the adjustable frequency reference oscillator comprising a frequency command input;
a timing controller configured to, when operating, provide a timing signal indicating whether radio signal processing by the radio frequency circuit is active or inactive; and
a frequency controller configured to, when operating and based on a synchronization reference signal:

adjust a frequency of the adjustable frequency reference oscillator based on the timing signal indicating that radio signal processing is inactive and based on a phase error between the synchronized frequency reference signal and a frequency based on the synchronization reference signal, and
inhibit adjustment of the frequency of the adjustable frequency reference oscillator based on the timing signal indicating that radio signal processing is active.

2.    The reference oscillator of claim 1, wherein the radio frequency circuit comprises a distributed coherent radar component.

3. The reference oscillator of claim 1 or 2, wherein the radio frequency circuit generates a waveform based on the timing signal and the synchronized frequency reference signal,

the waveform comprising an acquisition period and a reset period separate from the acquisition period, wherein the radio frequency circuit generates the acquisition period based on the timing signal indicating that radio signal processing is active and the reset period occurs based on the timing signal indicating radio signal processing is inactive.

4. The reference oscillator of any preceding claim, wherein the radio frequency circuit generates a waveform based on the timing signal and the synchronized frequency reference signal,

wherein the waveform comprises a chirp sequence comprising a plurality of acquisition periods with each acquisition period separated from an adjacent acquisition period by a respective pause interval, and wherein the chirp sequence is generated based on, and for a duration of, the timing signal indicating that radio signal processing is active, and
wherein the radio frequency circuit suspends chirp sequence generation based on the timing signal indicating that radio signal processing is inactive.

5. The reference oscillator of any preceding claim, wherein the adjustable frequency reference oscillator comprises a digitally controlled crystal oscillator, the digitally controlled crystal oscillator comprising a frequency command input, the digitally controlled crystal oscillator, when operating, produces a local frequency reference signal with a frequency based on the frequency command input and wherein the synchronized frequency reference signal is based on the local frequency reference signal.

6. The reference oscillator of any preceding claim, wherein the adjustable frequency reference oscillator comprises a phase locked loop, the phase locked loop comprising:

a programmable frequency divider processing the synchronized frequency reference signal and receiving a divisor command, the programmable frequency divider producing a divided frequency reference signal having a frequency corresponding to a frequency of the synchronized frequency reference signal divided by the divisor command; and
a time-to-digital converter, wherein the time-to-digital converter comprises a first input receiving a signal from a local frequency reference signal and a second input receiving the divided frequency reference signal, the time-to-digital converter providing an output proportional to a phase difference between signals arriving on the first input and the second input.

7. The reference oscillator of claim 6, further comprising a sigma-delta modulator configured to receive a time sequence of frequency commands to be applied to the adjustable frequency reference oscillator; and output the divisor command to the programmable frequency divider based on the time sequence of frequency commands.

8. The reference oscillator of any preceding claim, further comprising a wired communications data clock recovery circuit producing a recovered data clock, wherein the synchronization reference signal is based on the recovered data clock.

9. The reference oscillator of claim 8, wherein the wired communications data clock recovery circuit is configured to receive the timing signal, and wherein operations of the wired communications data clock recovery circuit are inhibited while the timing signal indicates that radio signal processing is active.

10. The reference oscillator of claim 8 or 9, wherein the frequency controller comprises:

a first frequency divider communicatively coupled to the wired communications data clock recovery circuit and configured to receive the recovered data clock and produce a first output having a frequency of the recovered data clock divided by a first divisor;
a second frequency divider communicatively coupled to the adjustable frequency reference oscillator and configured to receive the synchronized frequency reference signal and produce a second output having a frequency of the synchronized frequency reference signal divided by a second divisor;
a time-to-digital converter configured to receive the first output at a first input and the second output at a second input and configured to produce an output proportional to a phase difference between signals arriving on the first input and the second input;

a digital loop filter configured to receive the output proportional to the phase difference between signals arriving at the first input and the second input and produce a frequency command that is proportional to a phase difference between arriving on the first output and the second output; and

a hold circuit, communicatively coupled to the digital loop filter and the timing controller, the hold circuit configured to receive the timing signal and output the frequency command, and wherein the hold circuit inhibits outputting the frequency command based on the timing signal indicating that radio signal processing is active.

11. A method of synchronizing a reference oscillator, the method comprising:

adjusting a frequency of an adjustable frequency reference oscillator based on a timing signal indicating that radio signal processing is inactive and based on a phase error between a synchronized frequency reference signal and a frequency based on a synchronization reference signal, wherein:

the adjustable frequency reference oscillator provides the synchronized frequency reference signal for a radio frequency circuit, and
the timing signal indicates whether radio signal processing by a radio frequency circuit is active or inactive; and

inhibiting adjustment of the frequency of the adjustable frequency reference oscillator based on the timing signal indicating that radio signal processing is active.

12. The method of claim 11, the method further comprising performing the radio signal processing, wherein performing the radio signal processing comprises:

generating a waveform based on the timing signal and the synchronized frequency reference signal, wherein the waveform comprises an acquisition period and a reset period separate from the acquisition period;

generating, while the timing signal indicates that radio signal processing is active, the acquisition period based on the timing signal and the synchronized frequency reference signal; and
generating the reset period based on the timing signal indicating radio signal processing is inactive.

13. The method of claim 11 or 12, the method further comprising performing the radio signal processing, wherein performing the radio signal processing comprises:

generating a waveform based on the timing signal and the synchronized frequency reference signal, wherein the waveform comprises a chirp sequence comprising a plurality of acquisition periods with each acquisition period separated from an adjacent acquisition period by a respective pause interval;
generating the chirp sequence based on, and for a duration of, the timing signal indicating that radio signal processing is active; and
suspending the chirp sequence generation based on the timing signal indicating that radio signal processing is inactive.

14. The method of any of claims 11 to 13, wherein the synchronization reference signal is based on a recovered data clock recovered by a wired communications data clock recovery circuit, and wherein the method further comprises inhibiting operations of the wired communications data clock recovery circuit while the timing signal indicates that radio signal processing is active.

15. The method of any of claims 11 to 14, wherein the synchronization reference signal is based on a recovered data clock recovered by a wired communications data clock recovery circuit, and wherein adjusting the frequency of the adjustable frequency reference oscillator further comprises:

dividing a frequency of the recovered data clock to produce a first output having a frequency of the recovered data clock divided by a first divisor;
dividing a frequency of a local frequency reference signal to produce a second output having a frequency of the local frequency reference signal divided by a second divisor;
producing a frequency command that is proportional to a phase difference between the first output and the second output,
wherein adjusting the frequency of the adjustable frequency reference oscillator is based on the frequency command; and
inhibiting, based on the timing signal indicating that radio signal processing is active, output of the frequency command based on the phase difference.

**Amended claims in accordance with Rule 137(2) EPC.**

1. A reference oscillator, comprising:

   an adjustable frequency reference oscillator (204) providing a synchronized frequency reference signal (222) for a radio frequency circuit (240), the adjustable frequency reference oscillator comprising a frequency command input (230);

   a timing controller (208) configured to, when operating, provide a timing signal indicating whether radio signal processing by the radio frequency circuit is active or inactive;
   a wired communications data clock recovery circuit producing a recovered data clock, wherein a synchronization reference signal is based on the recovered data clock; and

   a frequency controller (210) configured to, when operating and based on the synchronization reference signal (128):

   adjust a frequency of the adjustable frequency reference oscillator based on the timing signal indicating that radio signal processing is inactive and based on a phase error between the synchronized frequency reference signal and a frequency based on the synchronization reference signal (128), and
   inhibit adjustment of the frequency of the adjustable frequency reference oscillator based on the timing signal indicating that radio signal processing is active.

2. The reference oscillator of claim 1, wherein the radio frequency circuit comprises a distributed coherent radar component.

3. The reference oscillator of claim 1 or 2, wherein the radio frequency circuit generates a waveform based on the timing signal and the synchronized frequency reference signal,

   the waveform comprising an acquisition period (714) and a reset period (716) separate from the acquisition period,
   wherein the radio frequency circuit generates the acquisition period based on the timing signal indicating that radio signal processing is active and the reset period occurs based on the timing signal indicating radio signal processing is inactive.

4. The reference oscillator of claim 1 or 2, wherein the radio frequency circuit generates a waveform based on the timing signal and the synchronized frequency reference signal,

   wherein the waveform comprises a chirp sequence comprising a plurality of acquisition periods (822) with each acquisition period separated from an adjacent acquisition period by a respective pause interval (814), and
   wherein the chirp sequence is generated based on, and for a duration of, the timing signal indicating that radio signal processing is active, and
   wherein the radio frequency circuit suspends chirp sequence generation based on the timing signal indicating that radio signal processing is inactive.

5. The reference oscillator of any preceding claim, wherein the adjustable frequency reference oscillator comprises a digitally controlled crystal oscillator (304), the digitally controlled crystal oscillator comprising a frequency command input, the digitally controlled crystal oscillator, when operating, produces a local frequency reference signal with a frequency based on the frequency command input and wherein the synchronized frequency reference signal is based on the local frequency reference signal.

6. The reference oscillator of any preceding claim, wherein the adjustable frequency reference oscillator comprises a phase locked loop, the phase locked loop comprising:

a programmable frequency divider (508) processing the synchronized frequency reference signal and receiving a divisor command, the programmable frequency divider producing a divided frequency reference signal having a frequency corresponding to a frequency of the synchronized frequency reference signal divided by the divisor command; and

a time-to-digital converter (502), wherein the time-to-digital converter comprises a first input receiving a signal from a local frequency reference signal and a second input receiving the divided frequency reference signal, the time-to-digital converter providing an output proportional to a phase difference between signals arriving on the first input and the second input.

7. The reference oscillator of claim 6, further comprising a sigma-delta modulator (510) configured to receive a time sequence of frequency commands to be applied to the adjustable frequency reference oscillator; and output the divisor command to the programmable frequency divider based on the time sequence of frequency commands.

8. The reference oscillator of any preceding claim, wherein the wired communications data clock recovery circuit is configured to receive the timing signal, and wherein operations of the wired communications data clock recovery circuit are inhibited while the timing signal indicates that radio signal processing is active.

9. The reference oscillator of any preceding claim, wherein the frequency controller comprises:

a first frequency divider (602) communicatively coupled to the wired communications data clock recovery circuit and configured to receive the recovered data clock and produce a first output having a frequency of the recovered data clock divided by a first divisor;

a second frequency divider (604) communicatively coupled to the adjustable frequency reference oscillator and configured to receive the synchronized frequency reference signal and produce a second output having a frequency of the synchronized frequency reference signal divided by a second divisor;

a time-to-digital converter (606) configured to receive the first output at a first input and the second output at a second input and configured to produce an output proportional to a phase difference between signals arriving on the first input and the second input;

a digital loop filter (608) configured to receive the output proportional to the phase difference between signals arriving at the first input and the second input and produce a frequency command that is proportional to a phase difference between arriving on the first output and the second output; and

a hold circuit (608), communicatively coupled to the digital loop filter and the timing controller, the hold circuit configured to receive the timing signal and output the frequency command, and wherein the hold circuit inhibits outputting the frequency command based on the timing signal indicating that radio signal processing is active.

10. A method of synchronizing a reference oscillator, the method comprising:

adjusting a frequency of an adjustable frequency reference oscillator based on a timing signal indicating that radio signal processing is inactive and based on a phase error between a synchronized frequency reference signal and a frequency based on a synchronization reference signal, wherein:

the synchronization reference signal is based on a recovered data clock, produced by a wired communications data clock recovery circuit;

the adjustable frequency reference oscillator provides the synchronized frequency reference signal for a radio frequency circuit, and

the timing signal indicates whether radio signal processing by a radio frequency circuit is active or inactive; and

inhibiting adjustment of the frequency of the adjustable frequency reference oscillator based on the timing signal indicating that radio signal processing is active.

11. The method of claim 10, the method further comprising performing the radio signal processing, wherein performing the radio signal processing comprises:

generating a waveform based on the timing signal and the synchronized frequency reference signal, wherein the waveform comprises an acquisition period and a reset period separate from the acquisition period;

generating, while the timing signal indicates that radio signal processing is active, the acquisition period based on the timing signal and the synchronized frequency reference signal; and

generating the reset period based on the timing signal indicating radio signal processing is inactive.

12. The method of claim 10 or 11, the method further comprising performing the radio signal processing, wherein performing the radio signal processing comprises:

generating a waveform based on the timing signal and the synchronized frequency reference signal, wherein the waveform comprises a chirp sequence comprising a plurality of acquisition periods with each acquisition period separated from an adjacent acquisition period by a respective pause interval; generating the chirp sequence based on, and for a duration of, the timing signal indicating that radio signal processing is active; and suspending the chirp sequence generation based on the timing signal indicating that radio signal processing is inactive.

13. The method of any of claims 10 to 12, wherein the synchronization reference signal is based on a recovered data clock recovered by a wired communications data clock recovery circuit, and wherein the method further comprises inhibiting operations of the wired communications data clock recovery circuit while the timing signal indicates that radio signal processing is active.

14. The method of any of claims 10 to 13, wherein the synchronization reference signal is based on a recovered data clock recovered by a wired communications data clock recovery circuit, and wherein adjusting the frequency of the adjustable frequency reference oscillator further comprises:

dividing a frequency of the recovered data clock to produce a first output having a frequency of the recovered data clock divided by a first divisor; dividing a frequency of a local frequency reference signal to produce a second output having a frequency of the local frequency reference signal divided by a second divisor; producing a frequency command that is proportional to a phase difference between the first output and the second output, wherein adjusting the frequency of the adjustable frequency reference oscillator is based on the frequency command; and

inhibiting, based on the timing signal indicating that radio signal processing is active, output of the frequency command based on the phase difference.

FIG. 1

EP 4 749 926 A1

FIG. 2

FIG. 3

FIG. 4

EP 4 749 926 A1

FIG. 5

FIG. 6

FIG. 7

FIG. 8

900

START

Adjusting a frequency of an adjustable frequency reference oscillator based on an indication of radio signal processing being inactive and based on a frequency error between a synchronized frequency reference signal and a frequency based on a synchronization reference signal ~902

Inhibiting adjustment of the frequency of the adjustable frequency reference oscillator based on the timing signal indicating that radio signal processing is active ~904

inhibiting operations of a wired communications data clock recovery circuit while the timing signal indicates that radio signal processing is active ~906

END

FIG. 9

START

_1000_

Dividing a frequency of the recovered data clock to produce a first output having a frequency of the recovered data clock divided by a first divisor

~1002

Dividing a frequency of a local frequency reference signal to produce a second output having a frequency of the local frequency reference signal divided by a second divisor

~1004

Producing a frequency command that is proportional to a frequency difference between the first output and the second output

~1006

Inhibiting, based on the timing signal indicating that radio signal processing is active, output of the frequency command based on the frequency difference

~1008

END

# FIG. 10

START

_1100_

Producing a divided frequency signal having a frequency corresponding to a frequency of the synchronized frequency reference signal divided by a divisor

~1102

Producing the synchronized reference frequency signal via a phased locked loop (PLL) based on a local frequency reference signal and the divided frequency signal

~1104

END

# FIG. 11

**FIG. 12**

Europäisches
Patentamt

European
Patent Office

Office européen
des brevets

# EUROPEAN SEARCH REPORT

**Application Number**

EP 24 21 5053

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2009 188854 A (NEW JAPAN RADIO CO LTD) 20 August 2009 (2009-08-20) | 1-5, 11-13 | INV. H03L7/08 |
| A | * paragraph [0015] - paragraph [0023]; figures 1-4 * | 6-10,14, 15 | H03L7/085 H03L7/197 |
|  | ----- |  |  |
| X | US 2012/214434 A1 (OTAKA SHOJI [JP] ET AL) 23 August 2012 (2012-08-23) | 1,2,5,11 |  |
| A | * paragraph [0020] - paragraph [0071]; figures 1-5 * | 3,4, 6-10, 12-15 |  |
|  | ----- |  |  |
| A | US 2024/310474 A1 (MORIERA CRISTIAN PAVAO [FR] ET AL) 19 September 2024 (2024-09-19) * paragraph [0016] - paragraph [0046]; figures 1, 2 * | 1-15 |  |
|  | ----- |  |  |

**TECHNICAL FIELDS SEARCHED (IPC)**

H03L
G01S

The present search report has been drawn up for all claims

| Place of search | Date of completion of the search | Examiner |
|---|---|---|
| The Hague | 15 May 2025 | Wienema, David |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 5053

This annex lists the patent family members relating to the patent documents cited in the above-mentioned European search report.
The members are as contained in the European Patent Office EDP file on
The European Patent Office is in no way liable for these particulars which are merely given for the purpose of information.

15-05-2025

| Patent document cited in search report | | Publication date | Patent family member(s) | | Publication date |
|---|---|---|---|---|---|
| JP 2009188854 | A | 20-08-2009 | NONE | | |
| US 2012214434 | A1 | 23-08-2012 | JP | 5225474 B2 | 03-07-2013 |
| | | | JP | WO2011077481 A1 | 02-05-2013 |
| | | | US | 2012214434 A1 | 23-08-2012 |
| | | | WO | 2011077481 A1 | 30-06-2011 |
| US 2024310474 | A1 | 19-09-2024 | CN | 118671765 A | 20-09-2024 |
| | | | EP | 4431972 A1 | 18-09-2024 |
| | | | US | 2024310474 A1 | 19-09-2024 |

EPO FORM P0459

For more details about this annex : see Official Journal of the European Patent Office, No. 12/82